# EUROPEAN PATENT APPLICATION

(11) **EP 4 369 009 A1**
(43) Date of publication of application: **15.05.2024**
(21) Application number: 21953669.5
(22) Date of filing: 17.08.2021
(51) Int. Cl.: G01R 31/28, G11C 29/00

(54) **POWER-OFF DETECTION METHOD AND RELATED DEVICE**

(71) Applicant: Huawei Technologies Co., Ltd., Longgang Shenzhen, Guangdong 518129 (CN)
(72) Inventor: GAO, Feng, Shenzhen, Guangdong 518129 (CN)
(74) Representative: Pfenning, Meinig & Partner mbB
(86) International application number: PCT/CN2021/112905
(87) International publication number: WO 2023/019415

(57) **Abstract**

A power-off detection method and a related device are provided. The method is applied to a storage controller (51). The storage controller (51) is coupled to a memory (52), the memory (52) is a non-volatile memory, and a volatile storage unit (521) is disposed in the memory (52). The storage controller (51) writes target data into the volatile storage unit (521) before entering a low power consumption mode. The storage controller (51) obtains data from the volatile storage unit (521) after detecting a wake-up request for exiting the low power consumption mode. The storage controller (51) determines, based on the data obtained from the volatile storage unit (521), whether the memory (52) has been powered off during the low power consumption mode of the storage controller (51); and if the memory (52) has been powered off during the low power consumption mode of the storage controller (51), the storage controller (51) initializes the memory (52). An abnormality can be avoided when the storage controller (51) accesses the memory (52) after exiting the low power consumption mode.

## Description

### TECHNICAL FIELD

This application relates to the field of data processing technologies, and in particular, to a power-off (power-off) detection method and a related device.

### BACKGROUND

A solid-state memory (solid-state memory) generally includes a storage controller and a storage medium. The storage controller accesses the storage medium through a memory interface. When the solid-state memory enters a low power consumption mode (also referred to as a sleep state), the storage controller also enters the low power consumption mode. When the solid-state memory is in the low power consumption mode, the storage medium may be powered off. If the storage medium has been powered off during the low power consumption mode of the solid-state memory, an abnormality occurs when the storage controller accesses the storage medium after exiting the low power consumption mode. Therefore, how to avoid the abnormality that occurs when the storage controller accesses the storage medium after exiting the low power consumption mode is a technical problem that needs to be urgently resolved.

### SUMMARY

Embodiments of this application disclose a power-off detection method and a related device, which can avoid an abnormality that occurs when a storage controller accesses a memory after exiting a low power consumption mode.

According to a first aspect, an embodiment of this application provides a power-off detection method, applied to a storage controller, where the storage controller is coupled to a memory, the memory is a non-volatile memory, and a volatile storage unit is disposed in the memory; and the method includes: writing target data into the volatile storage unit before the storage controller enters a low power consumption mode; obtaining data from the volatile storage unit after detecting a wake-up request for exiting the low power consumption mode; determining, based on the target data and the data obtained from the volatile storage unit, whether the memory has been powered off during the low power consumption mode of the storage controller; and initializing the memory if the memory has been powered off during the low power consumption mode of the storage controller. The volatile storage unit disposed in the memory may be a volatile storage unit existing in the memory, or may be a volatile storage unit that is specially and separately disposed in the memory to implement the technical solutions of this application.

In this embodiment of this application, the memory coupled to the storage controller is a non-volatile memory, and a volatile storage unit is disposed in the memory. When a host does not access data in the memory, the storage controller enters a low power consumption mode to reduce power consumption. The storage controller writes target data into the volatile storage unit before entering the low power consumption mode. During the low power consumption mode of the storage controller, when the host needs to access data in the memory, the storage controller detects a wake-up request for exiting the low power consumption mode, and obtains data from the volatile storage unit. Because the data stored in the volatile storage unit changes after power-off of the volatile storage unit, the storage controller may determine, based on the target data and the data obtained from the volatile storage unit, whether the memory has been powered off during the low power consumption mode of the storage controller. For example, the volatile storage unit previously stores target data, and the storage controller may determine, based on the obtained data, whether the target data stored in the volatile storage unit has changed, to determine whether the memory has been powered off. If the memory has not been powered off, after exiting the low power consumption mode, the storage controller may directly access the memory based on data access by the host to the memory. If the memory has been powered off, the storage controller initializes the memory, and the storage controller exits the low power consumption mode after completing memory initialization. In this way, after exiting the low power consumption mode, the storage controller may also access the memory based on data access by the host to the memory, thereby avoiding an access abnormality. A power-off detection principle provided in this application is: determining, based on whether the target data stored in the volatile storage unit has changed during the low power consumption mode of the storage controller, whether the memory has been powered off during the low power consumption mode of the storage controller. A power-off detection principle in a conventional technology is: continuously detecting, by the storage controller, a power supply of the memory during the low power consumption mode of the storage controller, to determine whether the memory has been powered off. The power-off detection principle provided in this application is different from the power-off detection principle of detecting the power supply of the memory in the conventional technology. For power-off detection in the conventional technology, the storage controller needs to continuously detect the power supply of the memory during the low power consumption mode, that is, the storage controller still performs power detection during the low power consumption mode. This causes power consumption, and is contrary to an original intention of enabling the storage controller to enter the low power consumption mode. For power-off detection provided in this application, when it is necessary to determine whether the memory has been powered off, the storage controller needs to detect only once whether the target data stored in the volatile storage unit in the memory has changed, to determine whether the memory has been powered off. Therefore, power consumption can be reduced. In addition, for power-off detection in the conventional technology, a structure of the storage controller needs to be improved. A power detection apparatus (for example, a power detection circuit) is disposed in the storage controller to continuously detect the power supply of the memory, and consequently, costs of the storage controller are increased. However, in this application, there is no need to improve the structure of the storage controller, and therefore, costs of the storage controller are not increased. In addition, because there are some volatile storage units in the memory, and an existing volatile storage unit in the memory may also be directly used as the volatile storage unit in this application, costs of the memory are not increased.

In a possible implementation, the determining, based on the target data and the data obtained from the volatile storage unit, whether the memory has been powered off during the low power consumption mode of the storage controller includes: determining, based on the data obtained from the volatile storage unit, whether the target data stored in the volatile storage unit has changed during the low power consumption mode of the storage controller; and determining, based on whether the target data stored in the volatile storage unit has changed during the low power consumption mode of the storage controller, whether the memory has been powered off during the low power consumption mode of the storage controller.

In this embodiment of this application, after power-off of the volatile storage unit, the data stored in the volatile storage unit changes. Before entering the low power consumption mode, the storage controller has written the target data into the volatile storage unit. If the memory has not been powered off during the low power consumption mode of the storage controller, the data obtained from the volatile storage unit includes all the target data, or in other words, included target data is the same as the previously written target data. If the memory has been powered off during the low power consumption mode of the storage controller, the data obtained from the volatile storage unit does not include the target data or includes a part of the target data, or in other words, included target data is different from the previously written target data. In this way, whether the target data stored in the volatile storage unit has changed is determined based on the data obtained from the volatile storage unit, so that whether the memory has been powered off can be determined.

In a possible implementation, if the target data stored in the volatile storage unit has not changed during the low power consumption mode of the storage controller, the memory has not been powered off during the low power consumption mode of the storage controller; or if the target data stored in the volatile storage unit has changed during the low power consumption mode of the storage controller, the memory has been powered off during the low power consumption mode of the storage controller.

In this embodiment of this application, if the target data stored in the volatile storage unit in the memory has not changed, it indicates that the memory has not been powered off; or if the target data stored in the volatile storage unit in the memory has changed, it indicates that the memory has been powered off, and the storage controller needs to initialize the memory, to avoid an abnormality that occurs when the storage controller accesses the memory after exiting the low power consumption mode.

In a possible implementation, the volatile storage unit is any one of the following: a cache (cache) or a random access memory (random access memory, RAM).

In this embodiment of this application, a cache and/or a random access memory is generally disposed inside the memory. The cache and the random access memory are volatile memories. The cache and/or the random access memory inside the memory is used as the volatile storage unit in this solution. The target data is written into the cache and/or the random access memory inside the memory, and there is no need to separately dispose a volatile storage unit in the memory. This can reduce costs.

In a possible implementation, the volatile storage unit is a status register (register), and the target data corresponds to a status of the status register; and the determining, based on the target data and the data obtained from the volatile storage unit, whether the memory has been powered off during the low power consumption mode of the storage controller includes: determining, based on data obtained from the status register, whether the status of the status register has changed during the low power consumption mode of the storage controller; and determining, based on whether the status of the status register has changed during the low power consumption mode of the storage controller, whether the memory has been powered off during the low power consumption mode of the storage controller.

In this embodiment of this application, the volatile storage unit may be a status register, and target data written into the status register corresponds to a status of the status register. Writing the target data into the status register is writing the status into the status register. The status of the status register changes after power-off. Based on this, whether the memory has been powered off may be determined based on whether the status of the status register has changed. Specifically, obtaining data from the status register is reading a status of the status register from the status register, and whether the status of the status register has changed during the low power consumption mode of the storage controller is determined based on the read status of the status register. If the status of the status register has changed, the memory has been powered off; or if the status of the status register has not changed, the memory has not been powered off.

According to a second aspect, an embodiment of this application provides a power-off detection method, applied to a storage controller, where the storage controller is coupled to a memory, the memory is a non-volatile memory, and a volatile storage unit is disposed in the memory; and the method includes: determining, based on whether target data stored in the volatile storage unit has changed during a low power consumption mode of the storage controller, whether the memory has been powered off during the low power consumption mode of the storage controller.

In this embodiment of this application, the memory coupled to the storage controller is a non-volatile memory, a volatile storage unit is disposed in the memory, and the volatile storage unit stores target data. A power-off detection principle provided in this application is: determining, based on whether the target data stored in the volatile storage unit has changed during the low power consumption mode of the storage controller, whether the memory has been powered off during the low power consumption mode of the storage controller. A power-off detection principle in a conventional technology is: continuously detecting, by the storage controller, a power supply of the memory during the low power consumption mode of the storage controller, to determine whether the memory has been powered off. The power-off detection principle provided in this application is different from the power-off detection principle of detecting the power supply of the memory in the conventional technology. For power-off detection in the conventional technology, the storage controller needs to continuously detect the power supply of the memory during the low power consumption mode, that is, the storage controller still performs power detection during the low power consumption mode. This causes power consumption, and is contrary to an original intention of enabling the storage controller to enter the low power consumption mode. For power-off detection provided in this application, when it is necessary to determine whether the memory has been powered off, the storage controller needs to detect only once whether the target data stored in the volatile storage unit in the memory has changed, to determine whether the memory has been powered off. Therefore, power consumption can be reduced. In addition, for power-off detection in the conventional technology, a structure of the storage controller needs to be improved. A power detection apparatus (for example, a power detection circuit) is disposed in the storage controller to continuously detect the power supply of the memory, and consequently, costs of the storage controller are increased. However, in this application, there is no need to improve the structure of the storage controller, and therefore, costs of the storage controller are not increased. In addition, because there are some volatile storage units in the memory, and an existing volatile storage unit in the memory may also be directly used as the volatile storage unit in this application, costs of the memory are not increased.

In a possible implementation, if the target data stored in the volatile storage unit has not changed during the low power consumption mode of the storage controller, the memory has not been powered off during the low power consumption mode of the storage controller; or if the target data stored in the volatile storage unit has changed during the low power consumption mode of the storage controller, the memory has been powered off during the low power consumption mode of the storage controller.

In this embodiment of this application, if the target data stored in the volatile storage unit in the memory has not changed, it indicates that the memory has not been powered off; or if the target data stored in the volatile storage unit in the memory has changed, it indicates that the memory has been powered off. In this way, power-off detection is implemented.

In a possible implementation, before the determining, based on whether target data stored in the volatile storage unit has changed during a low power consumption mode of the storage controller, whether the memory has been powered off during the low power consumption mode of the storage controller, the method further includes: writing the target data into the volatile storage unit before the storage controller enters the low power consumption mode; obtaining data from the volatile storage unit after detecting a wake-up request for exiting the low power consumption mode; and determining, based on the data obtained from the volatile storage unit, whether the target data stored in the volatile storage unit has changed during the low power consumption mode of the storage controller.

In this embodiment of this application, the storage controller writes target data into the volatile storage unit before entering the low power consumption mode. During the low power consumption mode of the storage controller, when a host needs to access data in the memory, the storage controller detects a wake-up request for exiting the low power consumption mode, and obtains data from the volatile storage unit. Because the data stored in the volatile storage unit changes after power-off of the volatile storage unit, the storage controller may determine, based on the data obtained from the volatile storage unit, whether the target data stored in the volatile storage unit has changed, to further determine whether the memory has been powered off.

In a possible implementation, the volatile storage unit is any one of the following: a cache or a random access memory.

In this embodiment of this application, a cache and/or a random access memory is generally disposed inside the memory. The cache and the random access memory are volatile memories. The cache and/or the random access memory inside the memory is used as the volatile storage unit in this solution. The target data is written into the cache and/or the random access memory inside the memory, and there is no need to separately dispose a volatile storage unit in the memory. This can reduce costs.

In a possible implementation, the volatile storage unit is a status register, and the target data corresponds to a status of the status register; and the determining, based on whether target data stored in the volatile storage unit has changed during a low power consumption mode of the storage controller, whether the memory has been powered off during the low power consumption mode of the storage controller includes: determining, based on whether the status of the status register has changed during the low power consumption mode of the storage controller, whether the memory has been powered off during the low power consumption mode of the storage controller.

In this embodiment of this application, the volatile storage unit may be a status register, and target data stored in the status register corresponds to a status of the status register. The status of the status register changes after power-off. Based on this, whether the memory has been powered off may be determined based on whether the status of the status register has changed.

In a possible implementation, before the determining, based on whether the status of the status register has changed during the low power consumption mode of the storage controller, whether the memory has been powered off during the low power consumption mode of the storage controller, the method further includes: writing the target data into the status register before the storage controller enters the low power consumption mode; obtaining data from the status register after detecting the wake-up request for exiting the low power consumption mode; and determining, based on the data obtained from the status register, whether the status of the status register has changed during the low power consumption mode of the storage controller.

In this embodiment of this application, the target data stored in the status register corresponds to the status of the status register. Before entering the low power consumption mode, the storage controller writes the target data into the status register, that is, writes the status into the status register. The storage controller obtains data from the status register, that is, reads a status of the status register from the status register. The storage controller determines, based on the data obtained from the status register, whether the status of the status register has changed, that is, determines, based on the read status of the status register, whether the status of the status register has changed. The memory has been powered off if the status of the status register has changed, or the memory has not been powered off if the status of the status register has not been changed. In this way, power-off detection is implemented.

In a possible implementation, if the memory has been powered off during the low power consumption mode of the storage controller, the method further includes: initializing the memory before the storage controller exits the low power consumption mode.

In this embodiment of this application, if the memory has been powered off during the low power consumption mode of the storage controller, the storage controller initializes the memory, and the storage controller exits the low power consumption mode after completing memory initialization. In this way, an access abnormality can be avoided when the storage controller accesses the memory after exiting the low power consumption mode.

According to a third aspect, an embodiment of this application provides a power-off detection apparatus, used for a storage controller, where the storage controller is coupled to a memory, the memory is a non-volatile memory, and a volatile storage unit is disposed in the memory; and the apparatus includes a processing unit, and the processing unit is configured to: write target data into the volatile storage unit before the storage controller enters a low power consumption mode; obtain data from the volatile storage unit after detecting a wake-up request for exiting the low power consumption mode; determine, based on the target data and the data obtained from the volatile storage unit, whether the memory has been powered off during the low power consumption mode of the storage controller; and initialize the memory if the memory has been powered off during the low power consumption mode of the storage controller.

In a possible implementation, the processing unit is specifically configured to: determine, based on the data obtained from the volatile storage unit, whether the target data stored in the volatile storage unit has changed during the low power consumption mode of the storage controller; and determine, based on whether the target data stored in the volatile storage unit has changed during the low power consumption mode of the storage controller, whether the memory has been powered off during the low power consumption mode of the storage controller.

In a possible implementation, the processing unit is specifically configured to: if the target data stored in the volatile storage unit has not changed during the low power consumption mode of the storage controller, determine that the memory has not been powered off during the low power consumption mode of the storage controller; or if the target data stored in the volatile storage unit has changed during the low power consumption mode of the storage controller, determine that the memory has been powered off during the low power consumption mode of the storage controller.

In a possible implementation, the volatile storage unit is any one of the following: a cache or a random access memory.

In a possible implementation, the volatile storage unit is a status register, and the target data corresponds to a status of the status register; and the processing unit is specifically configured to: determine, based on data obtained from the status register, whether the status of the status register has changed during the low power consumption mode of the storage controller; and determine, based on whether the status of the status register has changed during the low power consumption mode of the storage controller, whether the memory has been powered off during the low power consumption mode of the storage controller.

It should be noted that, for beneficial effects of the third aspect, refer to the description of the first aspect. Details are not described herein again.

According to a fourth aspect, an embodiment of this application provides a power-off detection apparatus, used for a storage controller, where the storage controller is coupled to a memory, the memory is a non-volatile memory, and a volatile storage unit is disposed in the memory; and the apparatus includes: a processing unit, configured to determine, based on whether target data stored in the volatile storage unit has changed during a low power consumption mode of the storage controller, whether the memory has been powered off during the low power consumption mode of the storage controller.

In a possible implementation, the processing unit is specifically configured to: if the target data stored in the volatile storage unit has not changed during the low power consumption mode of the storage controller, determine that the memory has not been powered off during the low power consumption mode of the storage controller; or if the target data stored in the volatile storage unit has changed during the low power consumption mode of the storage controller, determine that the memory has been powered off during the low power consumption mode of the storage controller.

In a possible implementation, before the determining, based on whether target data stored in the volatile storage unit has changed during a low power consumption mode of the storage controller, whether the memory has been powered off during the low power consumption mode of the storage controller, the processing unit is further configured to: write the target data into the volatile storage unit before the storage controller enters the low power consumption mode; obtain data from the volatile storage unit after detecting a wake-up request for exiting the low power consumption mode; and determine, based on the data obtained from the volatile storage unit, whether the target data stored in the volatile storage unit has changed during the low power consumption mode of the storage controller.

In a possible implementation, the volatile storage unit is any one of the following: a cache or a random access memory.

In a possible implementation, the volatile storage unit is a status register, and the target data corresponds to a status of the status register; and the processing unit is specifically configured to: determine, based on whether the status of the status register has changed during the low power consumption mode of the storage controller, whether the memory has been powered off during the low power consumption mode of the storage controller.

In a possible implementation, the processing unit is further configured to: write the target data into the status register before the storage controller enters the low power consumption mode; obtain data from the status register after detecting the wake-up request for exiting the low power consumption mode; and determine, based on the data obtained from the status register, whether the status of the status register has changed during the low power consumption mode of the storage controller.

In a possible implementation, if the memory has been powered off during the low power consumption mode of the storage controller, the processing unit is further configured to: initialize the memory before the storage controller exits the low power consumption mode.

It should be noted that, for beneficial effects of the fourth aspect, refer to the description of the second aspect. Details are not described herein again.

According to a fifth aspect, an embodiment of this application provides a storage controller, where the storage controller is coupled to a memory, the memory is a non-volatile memory, and a volatile storage unit is disposed in the memory; and the storage controller is configured to perform the method according to any one of the first aspect or the second aspect.

According to a sixth aspect, an embodiment of this application provides a storage device, including the storage controller in the fifth aspect and a memory, where the storage controller is coupled to the memory, the memory is a non-volatile memory, and a volatile storage unit is disposed in the memory.

According to a seventh aspect, an embodiment of this application provides an electronic device, where the electronic device includes the storage controller in the fifth aspect or the storage device in the sixth aspect.

According to an eighth aspect, an embodiment of this application provides a computer-readable storage medium, where the computer-readable storage medium includes a computer program, and when the computer program is run on a computer or a processor, the computer or the processor is enabled to perform the method according to any one of the first aspect or the second aspect.

According to a ninth aspect, an embodiment of this application provides a computer program product, where the computer program product includes a computer program, and when the computer program is run on a computer or a processor, the computer or the processor is enabled to perform the method according to any one of the first aspect or the second aspect.

### BRIEF DESCRIPTION OF DRAWINGS

FIG. 1 is a schematic diagram of a structure of a solid-state memory;
FIG. 2 is a flowchart of entering and exiting a low power consumption mode by a storage controller without power-off detection;
FIG. 3 is a schematic diagram of a structure of a solid-state memory having power-off detection based on a power supply;
FIG. 4 is a flowchart of entering and exiting a low power consumption mode by a storage controller based on power-off detection status of a power supply;
FIG. 5 is a schematic diagram of a structure of a storage device having a power-off detection function according to an embodiment of this application;
FIG. 6 is a flowchart of entering and exiting a low power consumption mode by a storage controller based on power-off detection status of a volatile storage unit according to an embodiment of this application;
FIG. 7 is a schematic flowchart of a power-off detection method according to an embodiment of this application;
FIG. 8 is a schematic flowchart of another power-off detection method according to an embodiment of this application;
FIG. 9 is a schematic diagram of a structure of a power-off detection apparatus according to an embodiment of this application;
FIG. 10 is a schematic diagram of a structure of another power-off detection apparatus according to an embodiment of this application;
FIG. 11 is a schematic diagram of a structure of an electronic device according to an embodiment of this application; and
FIG. 12 is a schematic diagram of a structure of another electronic device according to an embodiment of this application.

### DESCRIPTION OF EMBODIMENTS

To make the solutions of this application more comprehensible for a person skilled in the art, the following clearly and completely describes the technical solutions in embodiments of this application with reference to the accompanying drawings in embodiments of this application. It is clear that the described embodiments are merely some rather than all of embodiments of this application. All other embodiments obtained by a person of ordinary skill in the art based on embodiments of this application without creative efforts shall fall within the protection scope of this application.

The terms "include", "have", and any other variants thereof in the specification, claims, and accompanying drawings of this application are intended to cover non-exclusive inclusion. For example, a process, method, system, product, or device that includes a series of steps or units is not limited to the listed steps or units, but optionally further includes an unlisted step or unit, or optionally further includes another inherent step or unit for the process, method, product, or device.

It may be understood that, in this application, "at least one (item)" refers to one or more, and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate a, b, c, "a and b", "a and c", "b and c", or "a, b, and c", where a, b, and c may be singular or plural.

The "embodiment" mentioned herein means that specific features, structures, or characteristics described with reference to the embodiments may be included in at least one embodiment of this application. The phrase shown in various locations in the specification may not necessarily refer to a same embodiment, and is not an independent or optional embodiment exclusive from another embodiment. A person skilled in the art explicitly and implicitly understands that the embodiments described in this specification may be combined with other embodiments.

To facilitate understanding of embodiments of this application, a technical problem to be specifically resolved in this application is further analyzed and proposed.

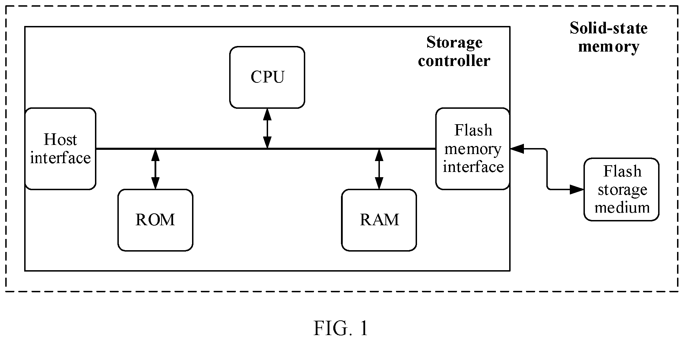

As shown in FIG. 1, a solid-state memory (solid-state memory) such as a solid-state disk (solid-state disk, SSD), a universal flash storage (universal flash storage, UFS), or an embedded multimedia card (embedded multimedia card, eMMC) includes a storage controller and a flash (flash) storage medium. The storage controller includes a central processing unit (central processing unit, CPU), a read-only memory (read-only memory, ROM), and a random access memory (random access memory, RAM). The storage controller is connected to the flash storage medium through a flash memory interface, to implement data read/write access to the flash storage medium. The storage controller is connected to a host through a host (host) interface.

For an application scenario sensitive to power consumption (for example, a consumer product such as a mobile phone), when a user does not access data in a solid-state memory, the solid-state memory is required to enter a low power consumption mode. In this case, a storage controller in the solid-state memory also enters the low power consumption mode. After the storage controller enters the low power consumption mode, modules such as a CPU, a ROM, and a RAM in the storage controller enter a sleep state or a disabled state. If the solid-state memory is in the low power consumption mode, when the user accesses the data in the solid-state memory, the storage controller is required to quickly exit the low power consumption mode and access a flash storage medium in the solid-state memory.

When the solid-state memory is in the low power consumption mode, even if power is continuously supplied to the flash storage medium in the solid-state memory, the flash storage medium may be powered off. For example, due to some abnormalities, a power supply of the flash storage medium drops or is powered off temporarily. If the flash storage medium has been powered off during the low power consumption mode of the storage controller, the storage controller needs to re-initialize the flash storage medium, so that the flash storage medium can still be normally accessed by the storage controller after the flash storage medium has been powered off. The initialization mainly includes memory interface link establishment, memory interface parameter configuration, memory working mode setting, and other operations, for example, establishing a flash memory interface link, configuring a flash memory interface parameter, and setting a flash storage medium working mode.

Currently, there are a plurality of solutions for avoiding an abnormality that occurs when a storage controller accesses a storage medium after exiting a low power consumption mode. Two of solutions are described herein as examples.

Existing solution 1: During the low power consumption mode, the storage controller does not detect whether the storage medium has been powered off, and initializes the storage medium each time before exiting the low power consumption mode.

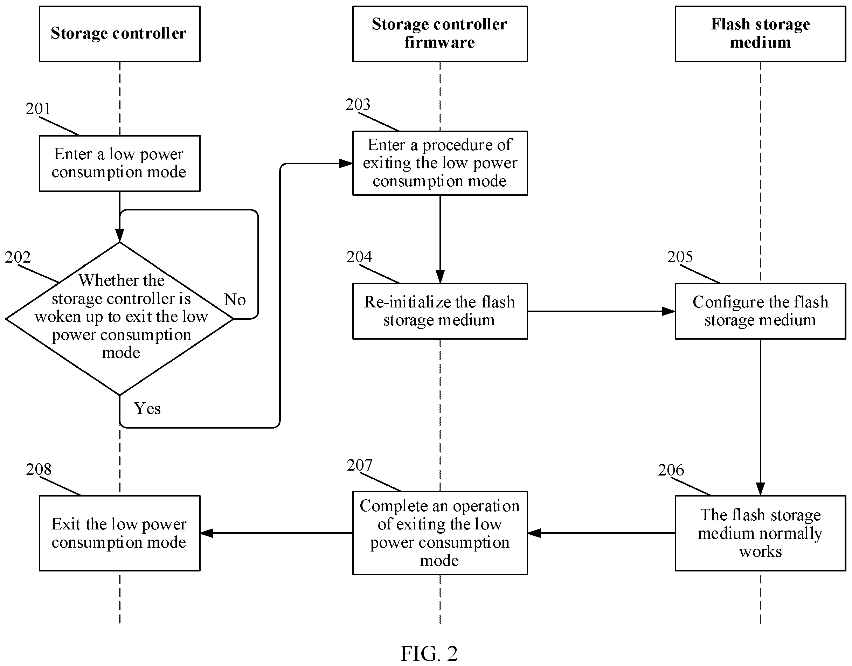

A structure of a solid-state memory for implementing the existing solution 1 may be shown in FIG. 1. An implementation procedure of the existing solution 1 is shown in FIG. 2, and includes the following steps.

Step 201: A storage controller enters a low power consumption mode.

Step 202: The storage controller determines whether the storage controller is to be woken up to exit the low power consumption mode, where if a determination result is that the storage controller is not woken up to exit the low power consumption mode, whether the storage controller is to be woken up to exit the low power consumption mode continues to be determined; or if a determination result is that the storage controller is woken up to exit the low power consumption mode, step 203 is performed. That the storage controller is to be woken up to exit the low power consumption mode means that the storage controller is to be woken up by a host to exit the low power consumption mode.

Step 203: Storage controller firmware enters a procedure of exiting the low power consumption mode. In other words, after entering the low power consumption mode, the storage controller detects that the storage controller is woken up by the host, and the storage controller firmware enters a processing procedure of exiting the low power consumption mode. The storage controller firmware is a driver stored inside the storage controller, that is, a firmware program installed on the storage controller.

Step 204: The storage controller firmware re-initializes the flash storage medium. In other words, the storage controller firmware performs re-initialization on the flash storage medium.

Step 205: The flash storage medium configures a flash register.

Step 206: The flash storage medium normally works. In other words, after configuration on a related register of the flash storage medium is completed, the flash storage medium enters a normal working mode.

Step 207: The storage controller firmware completes an operation of exiting the low power consumption mode. After completing a related operation of exiting the low power consumption mode, the storage controller firmware notifies the storage controller to exit the low power consumption mode.

Step 208: The storage controller exits the low power consumption mode. After exiting the low power consumption mode, the storage controller may normally receive an access request of the host for the flash storage medium.

In the existing solution 1, regardless of whether the power supply of the flash storage medium has been powered off in a period in which the storage controller exits the low power consumption mode, the storage controller re-initializes the flash storage medium before exiting the low power consumption mode. Generally, it is required that a delay of exiting the low power consumption mode is within 1 ms, and one initialization on the flash storage medium takes 100 µs, which is not conducive to quickly exiting the low power consumption mode to respond to an access request of the user.

Existing solution 2: The storage controller continuously detects, during the low power consumption mode, whether the storage medium has been powered off, and only if the storage medium has been powered off, the storage controller initializes the storage medium before exiting the low power consumption mode.

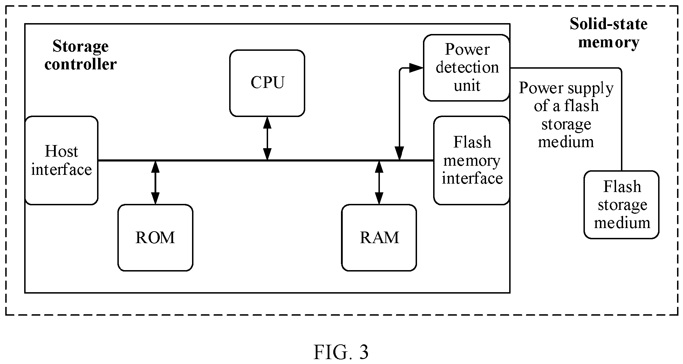

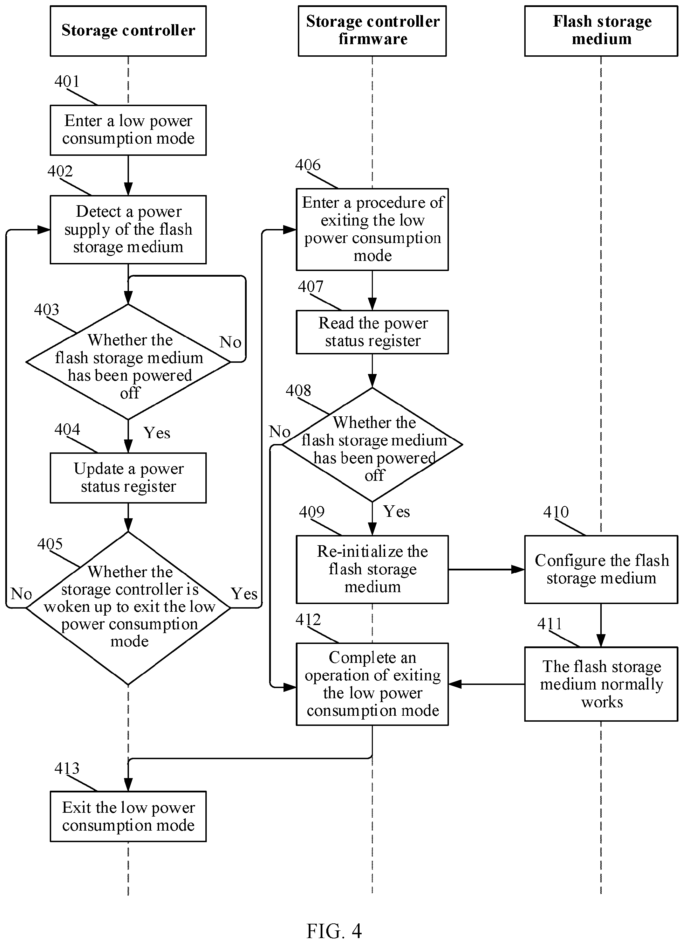

A structure of a solid-state memory for implementing the existing solution 2 may be shown in FIG. 3. The solid-state memory shown in FIG. 3 is improved based on the structure of the solid-state memory shown in FIG. 1. A power detection unit is added inside the storage controller. The power detection unit supports continuous detection on the power supply of the flash storage medium, or continuous detection on the power supply of the flash storage medium during the low power consumption mode of the storage controller, to determine whether the flash storage medium has been powered off. An implementation procedure of the existing solution 2 is shown in FIG. 4, and includes the following steps.

Step 401: A storage controller enters a low power consumption mode.

Step 402: The storage controller detects a power supply of a flash storage medium. Specifically, a power detection unit of the storage controller continuously detects the power supply of the flash storage medium during the low power consumption mode of the storage controller, to determine whether the flash storage medium has been powered off.

Step 403: The storage controller determines whether the flash storage medium has been powered off. If a determination result is that the flash storage medium has not been powered off, whether the flash storage medium has been powered off continues to be determined; or if a determination result is that the flash storage medium has been powered off, step 404 is performed.

Step 404: The storage controller updates a power status register. The power status register is a status register in the storage controller, and is configured to register a power status of the flash storage medium.

Step 405: The storage controller determines whether the storage controller is to be woken up to exit the low power consumption mode, where if a determination result is that the storage controller is not woken up to exit the low power consumption mode, step 403 is performed, and the power supply of the flash storage medium continues to be detected; or if a determination result is that the storage controller is woken up to exit the low power consumption mode, step 406 is performed. That the storage controller is to be woken up to exit the low power consumption mode means that the storage controller is to be woken up by a host to exit the low power consumption mode.

Step 406: Storage controller firmware enters a procedure of exiting the low power consumption mode. In other words, after the storage controller enters the low power consumption mode, the power detection unit continuously detects the power status of the flash storage medium, and when detecting that the flash storage medium is powered off or the power supply drops, updates status information of the power status register to indicate that the flash storage medium is powered off in the low power consumption mode; and when the host wakes up the storage controller to exit the low power consumption mode, the storage controller firmware enters the procedure of exiting the low power consumption mode.

Step 407: The storage controller firmware reads the power status register. In other words, the storage controller firmware reads status information that is in the power status register and that indicates the power status of the flash storage medium.

Step 408: The storage controller firmware determines whether the flash storage medium has been powered off. The storage controller firmware reads the status information that is in the power status register and that indicates the power status of the flash storage medium. If the status information indicates that power-off occurs, the storage controller firmware performs step 409 to re-initialize the flash storage medium, so that the flash storage medium enters a normal working mode. If the status information indicates that power-off does not occur, the storage controller firmware performs step 412 to complete a related operation of exiting the low power consumption mode, and notify the storage controller to exit the low power consumption mode.

Step 409: The storage controller firmware re-initializes the flash storage medium.

Step 410: The flash storage medium configures a flash register.

Step 411: The flash storage medium normally works. In other words, after configuration on a related register of the flash storage medium is completed, the flash storage medium enters a normal working mode.

Step 412: The storage controller firmware completes an operation of exiting the low power consumption mode.

Step 413: The storage controller exits the low power consumption mode.

In the existing solution 2, the storage controller supports detection on the power status of the flash storage medium in the low power consumption mode, so that power consumption of the storage controller in the low power consumption mode increases by about 50%, and costs are increased because the storage controller supports this function (where a power detection module is added).

Based on the above, as can be learned from analysis of the existing solutions, in the existing solutions, the storage controller re-initializes the flash storage medium each time before exiting the low power consumption mode; or when the storage controller is in the low power consumption mode, continuous power detection is performed on the flash storage medium, and the flash storage medium is re-initialized only after it is detected that a power-off operation occurs in the flash storage medium or the power supply drops. However, both of the two solutions have extra costs. The former increases a delay of exiting the low power consumption mode, and the latter requires that the storage controller or the solid-state memory supports continuous power detection on the flash storage medium during the low power consumption mode.

Therefore, technical problems to be resolved in this application may include the following.
(1) The storage controller does not support a power detection function for the flash storage medium in the low power consumption mode, and needs to re-initialize the flash storage medium each time before exiting the low power consumption mode, causing a problem that the delay of exiting the low power consumption mode is increased.
(2) The storage controller supports a power detection function for the flash storage medium in the low power consumption mode, but this causes a problem that power consumption in the low power consumption mode increases.
(3) The storage controller supports a power detection function for the flash storage medium in the low power consumption mode, but this causes a problem that costs of the storage controller are increased.

Based on the foregoing analysis on the existing problems, this application provides a solution for detecting, in a low power consumption mode, whether a power supply of a storage medium has been powered off. In the low power consumption mode, the storage controller in this application does not need to monitor the power status of the storage medium, and determines, based on a change of data or a status of a volatile storage unit in the storage medium, whether the power supply of the storage medium has been powered off, thereby resolving the problems in the existing technical solutions.

The following describes in detail technical solutions provided in this application with reference to specific implementations.

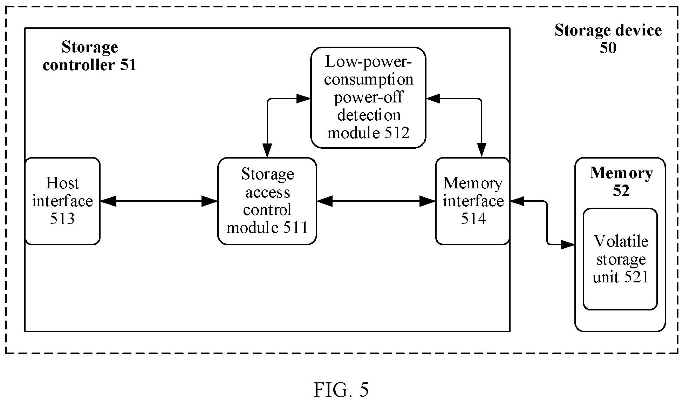

Refer to FIG. 5. FIG. 5 is a schematic diagram of a structure of a storage device having a power-off detection function according to an embodiment of this application. As shown in FIG. 5, the storage device 50 is a solid-state storage device. The storage device 50 includes a storage controller 51 and a memory 52. The storage controller 51 includes a storage access control module 511 and a low-power-consumption power-off detection module 512. The memory 52 includes a volatile storage unit 521. The storage controller 51 may communicate with a host (not shown in FIG. 5) through a host (host) interface 513, and the storage controller 51 may communicate with the memory 52 through a memory interface 514. Inside the storage controller 51, the storage access control module 511 communicates with the host through the host interface 513 and communicates with the memory 52 through the memory interface 514. The storage access control module 511 is further communicatively connected to the low-power-consumption power-off detection module 512, and the low-power-consumption power-off detection module 512 further communicates with the memory 52 through the memory interface 514.

It should be noted that, the storage controller 51 includes a CPU, and the CPU is responsible for controlling the storage controller 51. The storage controller 51 generally includes functional units such as the CPU, a RAM, and a ROM. The storage controller 51 and the memory (storage medium) 52 form the storage device 50. The storage device 50 may be a board including the storage controller 51 and the memory 52, or may be a chip in which the storage controller 51 and the memory 52 are packaged together.

The host interface 513 implements a connection between the storage controller 51 and the host, and is configured to receive access by the host to the storage device 50, and convert the access by the host into access to a back-end storage. A bus between the storage device 50 and the host may be an embedded multimedia card (embedded multimedia card, eMMC) bus, a universal flash storage (universal flash storage, UFS) bus, a peripheral component interconnect express (peripheral component interconnect express, PCIe) bus, an MVMe (non-volatile memory express) bus, or the like. In this way, the host interface 513 may be an interface such as an eMMC interface, a UFS interface, a PCIe interface, an NVMe interface, or the like. A possible specific implementation of the host interface 513 is not limited in this application.

The storage access control module 511 converts access to the back-end storage into access to the memory 52. The storage access control module 511 may be the CPU in the storage controller.

The memory interface 514 implements a connection between the storage controller 51 and the memory 52, and is configured to convert access by the storage access control module 511 to the memory 52 into a time sequence and a command operation for access to the memory 52. A bus between the storage controller 51 and the memory 52 may be an open NAND flash interface (open NAND flash interface, ONFI) bus, a TOGGLE bus, a common flash interface (common flash interface, CFI) bus, a serial peripheral interface (serial peripheral interface, SPI) bus, a double data rate random access memory (double data rate, DDR) bus, or the like. In this way, the memory interface 514 is an interface such as an ONFI, a TOGGLE bus interface, a CFI, an SPI, a DDR bus interface, or the like. A possible specific implementation of the memory interface 514 is not limited in this application.

The low-power-consumption power-off detection module 512 is configured to determine whether the memory 52 has been powered off during the low power consumption mode. The low-power-consumption power-off detection module 512 may be a hardware detection unit inside the storage controller. For example, the low-power-consumption power-off detection module 512 is the CPU in the storage controller. The low-power-consumption power-off detection module 512 may also be a detection function module implemented by the storage controller by using a firmware program.

The memory 52 is a storage medium. The memory 52 is a non-volatile memory. The memory 52 may be a non-volatile storage medium such as a flash (flash), a double data rate random access memory (double data rate, DDR), a dynamic random access memory (dynamic random access memory, DRAM), or a static random access memory (static random access memory, SRAM). A possible specific implementation of the memory 52 is not limited in this application.

Preferably, in this application, the memory 52 may be a flash (flash), and the storage device 50 may be a storage device such as an embedded multimedia card (embedded multimedia card, eMMC) chip, a universal flash storage (universal flash storage, UFS) chip, a solid-state disk (solid-state disk, SSD), a NAND flash (NAND flash), or a Norflash (Norflash) whose storage medium is a flash.

Optionally, in this application, the memory 52 may be a DDR, a DRAM, an SRAM, or the like, and the storage device 50 may be a storage device whose storage medium is a double data rate random access memory (double data rate, DDR), a dynamic random access memory (dynamic random access memory, DRAM), a static random access memory (static random access memory, SRAM), or the like. In this case, in this embodiment, a firmware program of the memory 52 and a device driver of the host are improved, that is, the host and the memory 52 need to be correspondingly programmed, so that the host and the memory 52 can implement corresponding functions in this application. A corresponding operation in this application is performed on a standard data transmission bus (for example, a DDR bus, an SPI bus, or the like) by modifying and controlling firmware of the memory such as a DRAM, a DDR, an SRAM, or the like.

The volatile storage unit 521 may be a unit in which data or a status stored in the memory changes after the memory is powered off. The volatile storage unit 521 may be a cache, a random access memory, a status register, or the like. For example, the storage device 50 is a NAND flash. The volatile storage unit 521 may be a cache (cache), a random access memory (random access memory, RAM), a register (register), or the like in the flash. A possible specific implementation of the volatile storage unit 521 is not limited in this application. The volatile storage unit 521 is configured to store target data. When the volatile storage unit 521 is a status register, the target data stored in the status register corresponds to a status of the status register.

In the low power consumption mode, the storage device 50 or the storage controller 51 in this application may determine, based on a change of the target data or the status stored in the volatile storage unit 521 in the memory 52, whether a power supply of the memory 52 has been powered off.

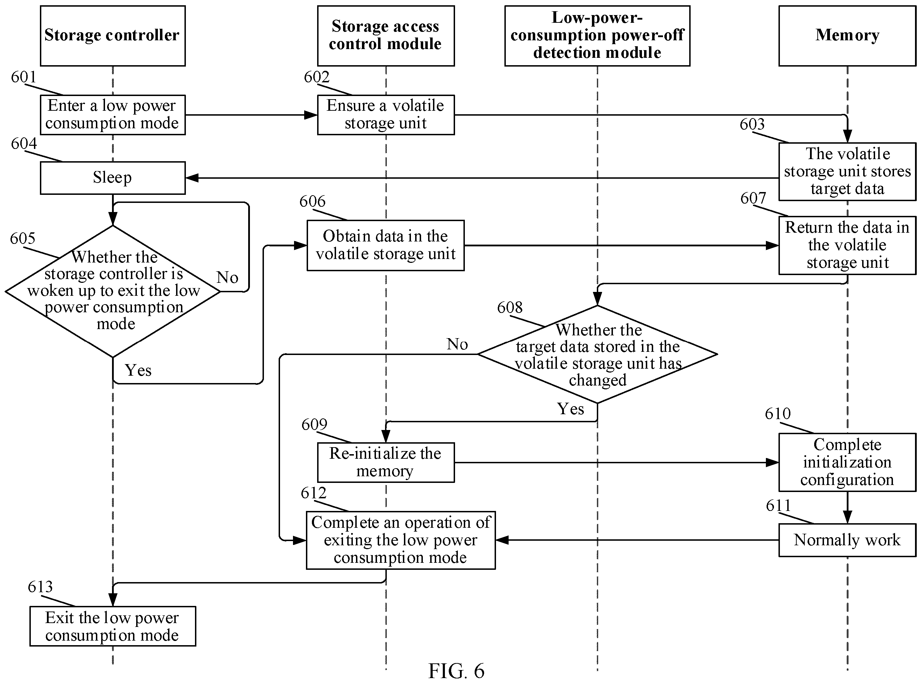

Refer to FIG. 6. FIG. 6 is a flowchart of entering and exiting a low power consumption mode by a storage controller based on power-off detection status of a volatile storage unit according to an embodiment of this application. The procedure shown in FIG. 6 is applied to the storage device 50 shown in FIG. 5, and includes but is not limited to the following steps.

Step 601: A storage controller enters a low power consumption mode.

Specifically, a host notifies the storage controller to enter the low power consumption mode. For example, the host sends an instruction to a storage device through a host interface, to instruct the storage device to enter the low power consumption mode, so that the storage controller starts to perform an operation of entering the low power consumption mode.

Step 602: A storage access control module ensures that a volatile storage unit in a memory stores target data.

In this application, whether the memory has been powered off during the low power consumption mode is determined based on whether the target data stored in the volatile storage unit in the memory has changed during the low power consumption mode. Therefore, before entering the low power consumption mode, the storage controller needs to ensure that the volatile storage unit in the memory stores the target data, and needs to write the target data into the volatile storage unit in the memory if the volatile storage unit does not store the target data.

The storage access control module in the storage controller operates the memory, and writes the target data into the volatile storage unit in the memory. Specifically, the storage access control module writes the target data into the volatile storage unit in the memory through a memory interface.

It should be noted that, before entering the low power consumption mode, the storage controller further needs to ensure that the memory or the volatile storage unit is in a power supply state. This is a prerequisite for power-off detection.

Step 603: The volatile storage unit in the memory stores the target data.

Specifically, if the volatile storage unit in the memory does not store the target data, the memory receives an operation instruction for writing the target data into the volatile storage unit, so that the volatile storage unit stores the target data.

Step 604: The storage controller sleeps. In other words, the storage controller enters a sleep state.

Step 605: The storage controller determines whether the storage controller is to be woken up to exit the low power consumption mode.

The storage controller in the sleep state may detect a wake-up request. The wake-up request is used by the storage controller to exit the low power consumption mode. When detecting the wake-up request, the storage controller starts to perform an operation of exiting the low power consumption mode. The wake-up request is a request from the outside of the storage device. For example, the wake-up request is an external access request received by the storage controller, and the access request may be a management request or an IO read/write request.

If the storage controller detects the wake-up request, and determines that the storage controller needs to be woken up to exit the low power consumption mode, the storage controller performs the operation of exiting the low power consumption mode, and performs step 606. If the storage controller does not detect the wake-up request, the storage controller keeps sleeping, and continues to determine whether the storage controller is to be woken up to exit the low power consumption mode.

Step 606: The storage access control module obtains data in the volatile storage unit.

Specifically, the storage access control module reads the data from the volatile storage unit. For example, the storage access control module sends, to the memory through the memory interface, an instruction for reading the data from the volatile storage unit.

Step 607: The memory returns the data in the volatile storage unit.

Specifically, the memory returns the data stored in the volatile storage unit to a low-power-consumption power-off detection module in the storage controller.

Step 608: The low-power-consumption power-off detection module determines whether the target data stored in the volatile storage unit has changed.

Specifically, after receiving the data in the volatile storage unit returned by the memory, the low-power-consumption power-off detection module determines, based on the data in the volatile storage unit returned by the memory, whether the target data stored in the volatile storage unit has changed during the low power consumption mode. For example, whether the data in the volatile storage unit returned by the memory includes the target data is determined through comparison, or whether the data obtained from the volatile storage unit includes all of the target data is determined. When the data in the volatile storage unit returned by the memory includes the target data, it is determined whether the target data has changed compared with target data previously stored, or whether the target data included in the data obtained from the volatile storage unit is the same as target data previously written.

In an example, the target data is fixed in code space, that is, the target data written into the volatile storage unit is fixed in code. In this way, after receiving the data in the volatile storage unit returned by the memory, the low-power-consumption power-off detection module may directly determine, based on the data in the volatile storage unit returned by the memory, whether the target data stored in the volatile storage unit has changed.

In another example, the target data is not fixed in the code space. In this case, the storage controller needs to locally store the target data, for example, store the target data in a ROM or a RAM in the storage controller. After receiving the data in the volatile storage unit returned by the memory, the low-power-consumption power-off detection module compares the data in the volatile storage unit returned by the memory with the locally stored target data, to determine whether the target data stored in the volatile storage unit has changed during the low power consumption mode.

If the target data stored in the volatile storage unit has changed during the low power consumption mode, it is determined that the memory has been powered off during the low power consumption mode, and step 609 is performed; or if the target data stored in the volatile storage unit has not changed during the low power consumption mode, it is determined that the memory has not been powered off during the low power consumption mode, and step 612 is performed.

Step 609: The storage access control module re-initializes the memory.

Specifically, the storage access control module sends, to the memory, a memory initialization request, where memory initialization mainly includes memory interface link establishment, memory interface parameter configuration, memory working mode setting, and other operations.

Step 610: The memory completes initialization configuration.

Specifically, the memory completes, based on the memory initialization request from the storage access control module, a configuration operation for the memory initialization.

Step 611: The memory normally works.

Specifically, the memory enters a normal working mode after completing an initialization operation, so that the memory can work normally, and then no access abnormality occurs when the storage controller accesses the memory.

Step 612: The storage access control module completes the operation of exiting the low power consumption mode.

Specifically, the storage access control module completes the operation of exiting the low power consumption mode, and notifies the storage controller that the storage controller may exit the low power consumption mode.

Step 613: The storage controller exits the low power consumption mode.

Specifically, after receiving the notification of exiting the low power consumption mode from the storage access control module, the storage controller exits the low power consumption mode. After exiting the low power consumption mode, the storage controller may access the memory based on an instruction of the host.

It should be noted that, that the storage controller exits the low power consumption mode is that the storage device exits the low power consumption mode.

In a possible implementation, the volatile storage unit is a status register, and the target data corresponds to a status of the status register. Therefore, when the status register stores the target data, the status of the status register is a preset status. In this way:

In step 602, the storage access control module ensures that the volatile storage unit in the memory stores the target data, that is, the storage access control module ensures that the status of the status register in the memory is a preset status. The storage access control module writes the target data into the volatile storage unit, that is, the storage access control module writes the preset status into the status register. For example, the target data is status information, and the status information is stored in the status register.

In step 603, the volatile storage unit in the memory stores the target data, that is, the status of the status register in the memory is a specified preset status.

In step 606, the storage access control module obtains the data in the volatile storage unit, that is, the storage access control module obtains the status of the status register.

In step 607, the memory returns the data in the volatile storage unit, that is, the memory returns the status of the status register.

In step 608, the low-power-consumption power-off detection module determines whether the target data stored in the volatile storage unit has changed, that is, the low-power-consumption power-off detection module determines whether the status of the status register returned by the memory has changed compared with the preset status. If the status of the status register has changed, the memory has been powered off during the low power consumption mode; or if the status of the status register has not changed, the memory has not been powered off during the low power consumption mode.

In this embodiment of this application, whether the memory has been powered off during the low power consumption mode is determined based on whether the data or the status stored in the volatile storage unit in the memory has changed during the low power consumption mode. This application has at least the following beneficial effects.
(1) Compared with a case that the storage controller does not support a function of performing power detection on the memory in the low power consumption mode, this application can reduce a period of time consumed by the storage controller or the storage device to exit the low power consumption mode. This is because the memory does not need to be initialized each time the storage controller or the storage device exits the low power consumption mode, which reduces a delay of exiting the low power consumption mode, and can save 100 µs.
(2) Compared with a case that the storage controller supports a function of continuously performing power detection on the memory in the low power consumption mode, this application can reduce power consumption of the storage controller in the low power consumption mode. This is because the storage controller does not need to run, in the low power consumption mode, a power detection apparatus for performing power detection on the memory, and operating power consumption of the storage controller is reduced, which can be reduced by 50%.
(3) Compared with a case that the storage controller supports a function of continuously performing power detection on the memory in the low power consumption mode, this application can reduce costs of the storage controller. This is because the storage controller does not need to reserve a power detection apparatus (for example, a power detection circuit) for performing power detection on the memory in the low power consumption mode, which reduces design and manufacturing costs of the storage controller.

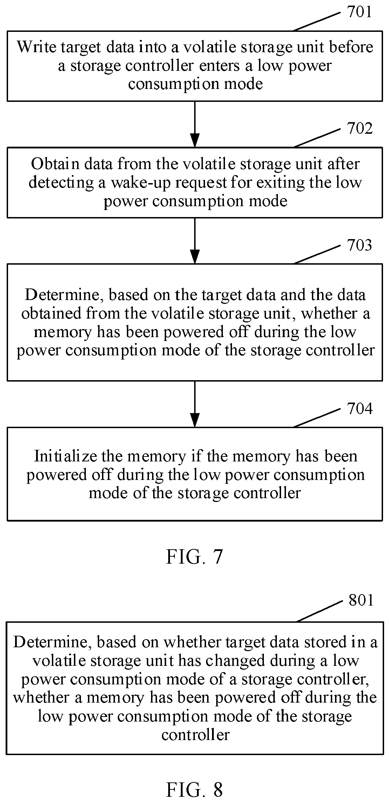

Refer to FIG. 7. FIG. 7 is a schematic flowchart of a power-off detection method according to an embodiment of this application. The method is applied to a storage controller, where the storage controller may be the storage controller 51 in the storage device 50 shown in FIG. 5, the storage controller is coupled to a memory, the memory is a non-volatile memory, and a volatile storage unit is disposed in the memory; and the method includes but is not limited to the following steps.

Step 701: Write target data into the volatile storage unit before the storage controller enters a low power consumption mode.

Step 702: Obtain data from the volatile storage unit after a wake-up request for exiting the low power consumption mode is detected.

Step 703: Determine, based on the target data and the data obtained from the volatile storage unit, whether the memory has been powered off during the low power consumption mode of the storage controller.

Step 704: Initialize the memory if the memory has been powered off during the low power consumption mode of the storage controller.

The volatile storage unit disposed in the memory may be a volatile storage unit existing in the memory, or may be a volatile storage unit that is specially and separately disposed in the memory to implement the technical solutions of this application.

It should be noted that, an application scenario of this application is as follows: In a process of exiting the low power consumption mode, the storage controller determines whether the memory has been powered off during the low power consumption mode, and the storage controller determines, based on a determination result, whether the memory needs to be initialized.

In this embodiment of this application, the memory coupled to the storage controller is a non-volatile memory, and a volatile storage unit is disposed in the memory. When a host does not access data in the memory, the storage controller enters a low power consumption mode to reduce power consumption. The storage controller writes target data into the volatile storage unit before entering the low power consumption mode. During the low power consumption mode of the storage controller, when the host needs to access data in the memory, the storage controller detects a wake-up request for exiting the low power consumption mode, and obtains data from the volatile storage unit. Because the data stored in the volatile storage unit changes after power-off of the volatile storage unit, the storage controller may determine, based on the data obtained from the volatile storage unit, whether the memory has been powered off during the low power consumption mode of the storage controller. For example, the volatile storage unit previously stores target data, and the storage controller may determine, based on the obtained data, whether the target data stored in the volatile storage unit has changed, to determine whether the memory has been powered off. If the memory has not been powered off, after exiting the low power consumption mode, the storage controller may directly access the memory based on data access by the host to the memory. If the memory has been powered off, the storage controller initializes the memory, and the storage controller exits the low power consumption mode after completing memory initialization. In this way, after exiting the low power consumption mode, the storage controller may also access the memory based on data access by the host to the memory, thereby avoiding an access abnormality. A power-off detection principle provided in this application is: determining, based on whether the target data stored in the volatile storage unit has changed during the low power consumption mode of the storage controller, whether the memory has been powered off during the low power consumption mode of the storage controller. A power-off detection principle in a conventional technology is: continuously detecting, by the storage controller, a power supply of the memory during the low power consumption mode of the storage controller, to determine whether the memory has been powered off. The power-off detection principle provided in this application is different from the power-off detection principle of detecting the power supply of the memory in the conventional technology. For power-off detection in the conventional technology, the storage controller needs to continuously detect the power supply of the memory during the low power consumption mode, that is, the storage controller still performs power detection during the low power consumption mode. This causes power consumption, and is contrary to an original intention of enabling the storage controller to enter the low power consumption mode. For power-off detection provided in this application, when it is necessary to determine whether the memory has been powered off, the storage controller needs to detect only once whether the target data stored in the volatile storage unit in the memory has changed, to determine whether the memory has been powered off. Therefore, power consumption can be reduced. In addition, for power-off detection in the conventional technology, a structure of the storage controller needs to be improved. A power detection apparatus (for example, a power detection circuit) is disposed in the storage controller to continuously detect the power supply of the memory, and consequently, costs of the storage controller are increased. However, in this application, there is no need to improve the structure of the storage controller, and therefore, costs of the storage controller are not increased. In addition, because there are some volatile storage units in the memory, and an existing volatile storage unit in the memory may also be directly used as the volatile storage unit in this application, costs of the memory are not increased.

In a possible implementation, the determining, based on the target data and the data obtained from the volatile storage unit, whether the memory has been powered off during the low power consumption mode of the storage controller includes: determining, based on the data obtained from the volatile storage unit, whether the target data stored in the volatile storage unit has changed during the low power consumption mode of the storage controller; and determining, based on whether the target data stored in the volatile storage unit has changed during the low power consumption mode of the storage controller, whether the memory has been powered off during the low power consumption mode of the storage controller.

In this embodiment of this application, after power-off of the volatile storage unit, the data stored in the volatile storage unit changes. Before entering the low power consumption mode, the storage controller has written the target data into the volatile storage unit. If the memory has not been powered off during the low power consumption mode of the storage controller, the data obtained from the volatile storage unit includes all the target data, or in other words, included target data is the same as the previously written target data. If the memory has been powered off during the low power consumption mode of the storage controller, the data obtained from the volatile storage unit does not include the target data or includes a part of the target data, or in other words, included target data is different from the previously written target data. In this way, whether the target data stored in the volatile storage unit has changed is determined based on the data obtained from the volatile storage unit, so that whether the memory has been powered off can be determined.

In a possible implementation, if the target data stored in the volatile storage unit has not changed during the low power consumption mode of the storage controller, the memory has not been powered off during the low power consumption mode of the storage controller; or if the target data stored in the volatile storage unit has changed during the low power consumption mode of the storage controller, the memory has been powered off during the low power consumption mode of the storage controller.

In this embodiment of this application, if the target data stored in the volatile storage unit in the memory has not changed, it indicates that the memory has not been powered off; or if the target data stored in the volatile storage unit in the memory has changed, it indicates that the memory has been powered off, and the storage controller needs to initialize the memory, to avoid an abnormality that occurs when the storage controller accesses the memory after exiting the low power consumption mode.

In a possible implementation, the volatile storage unit is any one of the following: a cache (cache) or a random access memory (random access memory, RAM).

In this embodiment of this application, a cache and/or a random access memory is generally disposed inside the memory. The cache and the random access memory are volatile memories. The cache and/or the random access memory inside the memory is used as the volatile storage unit in this solution. The target data is written into the cache and/or the random access memory inside the memory, and there is no need to separately dispose a volatile storage unit in the memory. This can reduce costs.

In a possible implementation, the volatile storage unit is a status register (register), and the target data corresponds to a status of the status register; and the determining, based on the target data and the data obtained from the volatile storage unit, whether the memory has been powered off during the low power consumption mode of the storage controller includes: determining, based on data obtained from the status register, whether the status of the status register has changed during the low power consumption mode of the storage controller; and determining, based on whether the status of the status register has changed during the low power consumption mode of the storage controller, whether the memory has been powered off during the low power consumption mode of the storage controller.

In this embodiment of this application, the volatile storage unit may be a status register, and target data written into the status register corresponds to a status of the status register. Writing the target data into the status register is writing the status into the status register. The status of the status register changes after power-off. Based on this, whether the memory has been powered off may be determined based on whether the status of the status register has changed. Specifically, obtaining data from the status register is reading a status of the status register from the status register, and whether the status of the status register has changed during the low power consumption mode of the storage controller is determined based on the read status of the status register. If the status of the status register has changed, the memory has been powered off; or if the status of the status register has not changed, the memory has not been powered off.

It should be noted that, for a specific procedure of the power-off detection method described in FIG. 7, refer to related descriptions in the embodiments shown in FIG. 5 and FIG. 6. Details are not described herein again.

Refer to FIG. 8. FIG. 8 is a schematic flowchart of a power-off detection method according to an embodiment of this application. The method is applied to a storage controller, where the storage controller may be the storage controller 51 in the storage device 50 shown in FIG. 5, the storage controller is coupled to a memory, the memory is a non-volatile memory, and a volatile storage unit is disposed in the memory; and the method includes but is not limited to the following steps.

Step 801: Determine, based on whether target data stored in the volatile storage unit has changed during a low power consumption mode of the storage controller, whether the memory has been powered off during the low power consumption mode of the storage controller.

It should be noted that, an application scenario of this application is as follows: In a process of exiting the low power consumption mode, the storage controller determines whether the memory has been powered off during the low power consumption mode, and the storage controller determines, based on a determination result, whether the memory needs to be initialized.

In this embodiment of this application, the memory coupled to the storage controller is a non-volatile memory, a volatile storage unit is disposed in the memory, and the volatile storage unit stores target data. A power-off detection principle provided in this application is: determining, based on whether the target data stored in the volatile storage unit has changed during the low power consumption mode of the storage controller, whether the memory has been powered off during the low power consumption mode of the storage controller. A power-off detection principle in a conventional technology is: continuously detecting, by the storage controller, a power supply of the memory during the low power consumption mode of the storage controller, to determine whether the memory has been powered off. The power-off detection principle provided in this application is different from the power-off detection principle of detecting the power supply of the memory in the conventional technology. For power-off detection in the conventional technology, the storage controller needs to continuously detect the power supply of the memory during the low power consumption mode, that is, the storage controller still performs power detection during the low power consumption mode. This causes power consumption, and is contrary to an original intention of enabling the storage controller to enter the low power consumption mode. For power-off detection provided in this application, when it is necessary to determine whether the memory has been powered off, the storage controller needs to detect only once whether the target data stored in the volatile storage unit in the memory has changed, to determine whether the memory has been powered off. Therefore, power consumption can be reduced. In addition, for power-off detection in the conventional technology, a structure of the storage controller needs to be improved. A power detection apparatus (for example, a power detection circuit) is disposed in the storage controller to continuously detect the power supply of the memory, and consequently, costs of the storage controller are increased. However, in this application, there is no need to improve the structure of the storage controller, and therefore, costs of the storage controller are not increased. In addition, because there are some volatile storage units in the memory, and an existing volatile storage unit in the memory may also be directly used as the volatile storage unit in this application, costs of the memory are not increased.

In a possible implementation, if the target data stored in the volatile storage unit has not changed during the low power consumption mode of the storage controller, the memory has not been powered off during the low power consumption mode of the storage controller; or if the target data stored in the volatile storage unit has changed during the low power consumption mode of the storage controller, the memory has been powered off during the low power consumption mode of the storage controller.

In this embodiment of this application, if the target data stored in the volatile storage unit in the memory has not changed, it indicates that the memory has not been powered off; or if the target data stored in the volatile storage unit in the memory has changed, it indicates that the memory has been powered off. In this way, power-off detection is implemented.

In a possible implementation, before the determining, based on whether target data stored in the volatile storage unit has changed during a low power consumption mode of the storage controller, whether the memory has been powered off during the low power consumption mode of the storage controller, the method further includes: writing the target data into the volatile storage unit before the storage controller enters the low power consumption mode; obtaining data from the volatile storage unit after detecting a wake-up request for exiting the low power consumption mode; and determining, based on the data obtained from the volatile storage unit, whether the target data stored in the volatile storage unit has changed during the low power consumption mode of the storage controller.

In this embodiment of this application, the storage controller writes target data into the volatile storage unit before entering the low power consumption mode. During the low power consumption mode of the storage controller, when a host needs to access data in the memory, the storage controller detects a wake-up request for exiting the low power consumption mode, and obtains data from the volatile storage unit. Because the data stored in the volatile storage unit changes after power-off of the volatile storage unit, the storage controller may determine, based on the data obtained from the volatile storage unit, whether the target data stored in the volatile storage unit has changed, to further determine whether the memory has been powered off.

In a possible implementation, the volatile storage unit is any one of the following: a cache or a random access memory.

In this embodiment of this application, a cache and/or a random access memory is generally disposed inside the memory. The cache and the random access memory are volatile memories. The cache and/or the random access memory inside the memory is used as the volatile storage unit in this solution. The target data is written into the cache and/or the random access memory inside the memory, and there is no need to separately dispose a volatile storage unit in the memory. This can reduce costs.

In a possible implementation, the volatile storage unit is a status register, and the target data corresponds to a status of the status register; and the determining, based on whether target data stored in the volatile storage unit has changed during a low power consumption mode of the storage controller, whether the memory has been powered off during the low power consumption mode of the storage controller includes: determining, based on whether the status of the status register has changed during the low power consumption mode of the storage controller, whether the memory has been powered off during the low power consumption mode of the storage controller.

In this embodiment of this application, the volatile storage unit may be a status register, and target data stored in the status register corresponds to a status of the status register. The status of the status register changes after power-off. Based on this, whether the memory has been powered off may be determined based on whether the status of the status register has changed.

In a possible implementation, before the determining, based on whether the status of the status register has changed during the low power consumption mode of the storage controller, whether the memory has been powered off during the low power consumption mode of the storage controller, the method further includes: writing the target data into the status register before the storage controller enters the low power consumption mode; obtaining data from the status register after detecting the wake-up request for exiting the low power consumption mode; and determining, based on the data obtained from the status register, whether the status of the status register has changed during the low power consumption mode of the storage controller.

In this embodiment of this application, the target data stored in the status register corresponds to the status of the status register. Before entering the low power consumption mode, the storage controller writes the target data into the status register, that is, writes the status into the status register. The storage controller obtains data from the status register, that is, reads a status of the status register from the status register. The storage controller determines, based on the data obtained from the status register, whether the status of the status register has changed, that is, determines, based on the read status of the status register, whether the status of the status register has changed. The memory has been powered off if the status of the status register has changed, or the memory has not been powered off if the status of the status register has not been changed. In this way, power-off detection is implemented.

In a possible implementation, if the memory has been powered off during the low power consumption mode of the storage controller, the method further includes: initializing the memory before the storage controller exits the low power consumption mode.

In this embodiment of this application, if the memory has been powered off during the low power consumption mode of the storage controller, the storage controller initializes the memory, and the storage controller exits the low power consumption mode after completing memory initialization. In this way, an access abnormality can be avoided when the storage controller accesses the memory after exiting the low power consumption mode.

It should be noted that, for a specific procedure of the power-off detection method described in FIG. 8, refer to related descriptions in the embodiments shown in FIG. 5, FIG. 6, and FIG. 7. Details are not described herein again.

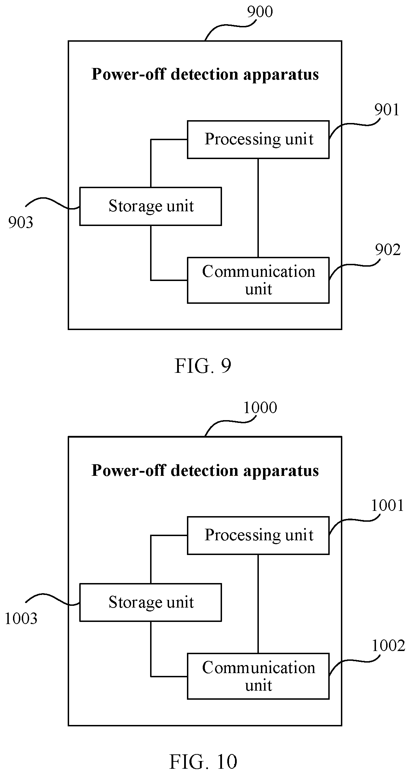

Refer to FIG. 9. FIG. 9 is a schematic diagram of a structure of a power-off detection apparatus according to an embodiment of this application. The power-off detection apparatus 900 is used for a storage controller, where the storage controller is coupled to a memory, the memory is a non-volatile memory, and a volatile storage unit is disposed in the memory. The power-off detection apparatus includes a processing unit 901 and a communication unit 902, where the processing unit 901 is configured to perform any step in the method embodiment shown in FIG. 7, and when performing data transmission such as obtaining, the communication unit 902 may be optionally invoked to complete a corresponding operation. Details are described below.

In a possible implementation, the processing unit 901 is configured to: write target data into the volatile storage unit before the storage controller enters a low power consumption mode; obtain data from the volatile storage unit after detecting a wake-up request for exiting the low power consumption mode; determine, based on the target data and the data obtained from the volatile storage unit, whether the memory has been powered off during the low power consumption mode of the storage controller; and initialize the memory if the memory has been powered off during the low power consumption mode of the storage controller.

In a possible implementation, the processing unit 901 is specifically configured to: determine, based on the data obtained from the volatile storage unit, whether the target data stored in the volatile storage unit has changed during the low power consumption mode of the storage controller; and determine, based on whether the target data stored in the volatile storage unit has changed during the low power consumption mode of the storage controller, whether the memory has been powered off during the low power consumption mode of the storage controller.

In a possible implementation, the processing unit 901 is specifically configured to: if the target data stored in the volatile storage unit has not changed during the low power consumption mode of the storage controller, determine that the memory has not been powered off during the low power consumption mode of the storage controller; or if the target data stored in the volatile storage unit has changed during the low power consumption mode of the storage controller, determine that the memory has been powered off during the low power consumption mode of the storage controller.

In a possible implementation, the volatile storage unit is any one of the following: a cache or a random access memory.

In a possible implementation, the volatile storage unit is a status register, and the target data corresponds to a status of the status register; and the processing unit 901 is specifically configured to: determine, based on data obtained from the status register, whether the status of the status register has changed during the low power consumption mode of the storage controller; and determine, based on whether the status of the status register has changed during the low power consumption mode of the storage controller, whether the memory has been powered off during the low power consumption mode of the storage controller.

The power-off detection apparatus 900 may further include a storage unit 903, configured to store program code and data of the storage controller. The processing unit 901 may be a processor, the communication unit 902 may be a transceiver, and the storage unit 903 may be a memory (for example, a RAM or a ROM).

It should be noted that, for implementation of each unit of the power-off detection apparatus 900, correspondingly refer to corresponding descriptions in the method embodiment shown in FIG. 7, and for beneficial effects brought by the power-off detection apparatus 900, refer to the corresponding descriptions in the method embodiment shown in FIG. 7. Details are not described herein again.

Refer to FIG. 10. FIG. 10 is a schematic diagram of a structure of a power-off detection apparatus according to an embodiment of this application. The power-off detection apparatus 1000 is used for a storage controller, where the storage controller is coupled to a memory, the memory is a non-volatile memory, and a volatile storage unit is disposed in the memory. The power-off detection apparatus includes a processing unit 1001 and a communication unit 1002, where the processing unit 1001 is configured to perform any step in the method embodiment shown in FIG. 8, and when performing data transmission such as obtaining, the communication unit 1002 may be optionally invoked to complete a corresponding operation. Details are described in the following.

In a possible implementation, the processing unit 1001 is configured to: determine, based on whether target data stored in the volatile storage unit has changed during a low power consumption mode of the storage controller, whether the memory has been powered off during the low power consumption mode of the storage controller.

In a possible implementation, the processing unit 1001 is specifically configured to: if the target data stored in the volatile storage unit has not changed during the low power consumption mode of the storage controller, determine that the memory has not been powered off during the low power consumption mode of the storage controller; or if the target data stored in the volatile storage unit has changed during the low power consumption mode of the storage controller, determine that the memory has been powered off during the low power consumption mode of the storage controller.

In a possible implementation, before the determining, based on whether target data stored in the volatile storage unit has changed during a low power consumption mode of the storage controller, whether the memory has been powered off during the low power consumption mode of the storage controller, the processing unit 1001 is further configured to: write the target data into the volatile storage unit before the storage controller enters the low power consumption mode; obtain data from the volatile storage unit after detecting a wake-up request for exiting the low power consumption mode; and determine, based on the data obtained from the volatile storage unit, whether the target data stored in the volatile storage unit has changed during the low power consumption mode of the storage controller.

In a possible implementation, the volatile storage unit is any one of the following: a cache or a random access memory.

In a possible implementation, the volatile storage unit is a status register, and the target data corresponds to a status of the status register; and the processing unit 1001 is specifically configured to: determine, based on whether the status of the status register has changed during the low power consumption mode of the storage controller, whether the memory has been powered off during the low power consumption mode of the storage controller.

In a possible implementation, the processing unit 1001 is further configured to: write the target data into the status register before the storage controller enters the low power consumption mode; obtain data from the status register after detecting the wake-up request for exiting the low power consumption mode; and determine, based on the data obtained from the status register, whether the status of the status register has changed during the low power consumption mode of the storage controller.

In a possible implementation, if the memory has been powered off during the low power consumption mode of the storage controller, the processing unit 1001 is further configured to: initialize the memory before the storage controller exits the low power consumption mode.

The power-off detection apparatus 1000 may further include a storage unit 1003, configured to store program code and data of the storage controller. The processing unit 1001 may be a processor, the communication unit 1002 may be a transceiver, and the storage unit 1003 may be a memory (for example, a RAM or a ROM).

It should be noted that, for implementation of each unit of the power-off detection apparatus 1000, correspondingly refer to corresponding descriptions in the method embodiment shown in FIG. 8, and for beneficial effects brought by the power-off detection apparatus 1000, refer to the corresponding descriptions in the method embodiment shown in FIG. 8. Details are not described herein again.

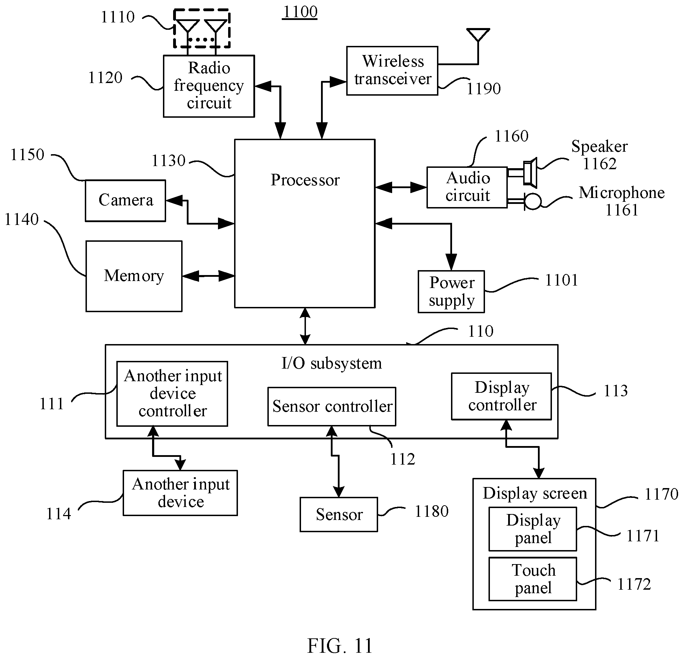

Refer to FIG. 11. FIG. 11 is a schematic diagram of a structure of an electronic device according to an embodiment of this application. The electronic device 1100 may include an antenna system 1110, a radio frequency (radio frequency, RF) circuit 1120, a processor 1130, a memory 1140, a camera 1150, an audio circuit 1160, a display screen 1170, one or more sensors 1180, a wireless transceiver 1190, and the like.

The memory 1140 may be the storage device 50 shown in FIG. 5, and the memory 1140 may perform the method shown in FIG. 6, FIG. 7, or FIG. 8. Alternatively, the memory 1140 includes a storage controller, and the storage controller in the memory 1140 may perform the method shown in FIG. 6, FIG. 7, or FIG. 8.

The antenna system 1110 may be one or more antennas, or may be an antenna array including a plurality of antennas. The radio frequency circuit 1120 may include one or more analog radio frequency transceivers. The radio frequency circuit 1120 may further include one or more digital radio frequency transceivers. The radio frequency circuit 1120 is coupled to the antenna system 1110. It may be understood that, in embodiments of this application, coupling refers to a mutual connection in a specific manner, including a direct connection or an indirect connection through another device, for example, a connection through various interfaces, transmission lines, buses, or the like. The radio frequency circuit 1120 may be used for various types of cellular or wireless communication.

The processor 1130 may include a communication processor. The communication processor may be configured to control the radio frequency circuit 1120 to send and receive a signal through the antenna system 1110. The signal may be a voice signal, a media signal, or a control signal. The processor 1130 may include various general-purpose processing devices, for example, a general-purpose central processing unit (central processing unit, CPU), a system on chip (system on chip, SOC), a processor integrated on an SOC, an independent processor chip, a controller, or the like. The processor 1130 may further include a dedicated processing device, for example, an application-specific integrated circuit (application-specific integrated circuit, ASIC), a field programmable gate array (field programmable gate array, FPGA), a digital signal processor (digital signal processor, DSP), a dedicated video or graphics processor, a graphics processing unit (graphics processing unit, GPU), a neural-network processing unit (neural-network processing unit, NPU), and the like. The processor 1130 may be a processor group including a plurality of processors, and the plurality of processors are coupled to each other through one or more buses. The processor may include an analog-to-digital converter (analog-to-digital converter, ADC) and a digital-to-analog converter (digital-to-analog converter, DAC), to implement signal connection between different components of the apparatus.

The memory 1140 is coupled to the processor 1130. Specifically, the memory 1140 may be coupled to the processor 1130 through one or more memory controllers. The memory 1140 may be configured to store computer program instructions, and includes a computer operating system (operating system, OS), various user applications, user data, and the like. The processor 1130 may read the computer program instructions or the user data from the memory 1140, or store the computer program instructions or the user data into the memory 1140, to implement a related processing function. The memory 1140 may be a non-volatile memory, for example, an EMMC (embedded multimedia card, embedded multimedia card), a UFS (universal flash storage, universal flash storage), a read-only memory (read-only memory, ROM), or another type of static storage device that can store static information and instructions; or may be a volatile memory (volatile memory), for example, a random access memory (random access memory, RAM), a static random access memory (static random access memory, SRAM), or another type of dynamic storage device that can store information and instructions; or may be an electrically erasable programmable read-only memory (electrically erasable programmable read-only memory, EEPROM), a compact disc read-only memory (compact disc read-only memory, CD-ROM) or another optical disk memory, an optical disc memory (including a compact disc, a laser disc, a digital versatile disc, a Blu-ray disc, and the like), a magnetic disk storage medium, or another magnetic storage device. But this application is not limited thereto. Optionally, the memory 1140 may be independent of the processor 1130, or the memory 1140 may be integrated with the processor 1130.

The camera 1150 is configured to collect an image or a video, and the audio circuit 1160 is coupled to the processor 1130. The audio circuit 1160 may include a microphone 1161 and a speaker 1162. The microphone 1161 may receive sound input from the outside, and the speaker 1162 may play audio data.

The display screen 1170 is configured to provide a user with various display interfaces or various types of selectable menu information. For example, content displayed by the display screen 1170 includes but is not limited to a soft keyboard, a virtual mouse, a virtual key, an icon, and the like. The displayed content is associated with a specific internal module or function. The display screen 1170 may further accept user input. Specifically, the display screen 1170 may include a display panel 1171 and a touch panel 1172.

The sensor 1180 may include an image sensor, a motion sensor, a proximity sensor, an ambient noise sensor, a sound sensor, an accelerometer, a temperature sensor, a gyroscope, another type of sensor, or a combination of various forms thereof. The processor 1130 drives, through a sensor controller 112 in an I/O subsystem 110, the sensor 1180 to receive various types of information such as audio information, image information, or motion information. The sensor 1180 transmits the received information to the processor 1130 for processing.

For the wireless transceiver 1190, the wireless transceiver 1190 may provide a wireless connection capability for another device. The another device may be a peripheral device such as a wireless headset, a Bluetooth headset, a wireless mouse, or a wireless keyboard, or may be a wireless network, for example, a wireless fidelity (wireless fidelity, Wi-Fi) network, a wireless personal area network (wireless personal area network, WPAN), or a WLAN thereof. The wireless transceiver 1190 may be a Bluetooth-compatible transceiver, and is configured to wirelessly couple the processor 1130 to a peripheral device such as a Bluetooth headset or a wireless mouse. The wireless transceiver 1190 may alternatively be a Wi-Fi-compatible transceiver, and is configured to wirelessly couple the processor 1130 to a wireless network or another device.

The electronic device 1100 may further include another input device 114 that is coupled to the processor 1130 to receive various types of user input, for example, receive an input number, name, address, media selection, and the like. The another input device 114 may include a keyboard, a physical button (a press button, a rocker button, or the like), a dial, a slide switch, and the like. The electronic device 1100 may further include the I/O subsystem 110 and a power supply 1101. It may be understood that, the electronic device 1100 in FIG. 11 is merely an example, and does not constitute a limitation on a specific form of the electronic device 1100. The electronic device 1100 may further include another component that exists but is not shown in FIG. 11 or that may be added in the future.

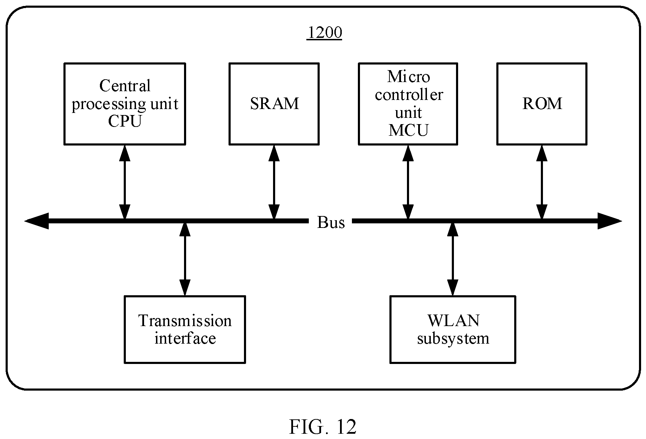

Refer to FIG. 12. FIG. 12 is a schematic diagram of a structure of another electronic device according to an embodiment of this application. The electronic device 1200 includes at least one CPU and a memory. A type of the memory may include, for example, an SRAM and a ROM, a micro controller unit (micro controller unit, MCU), a WLAN subsystem, a bus, and a transmission interface, and the like. Although not shown in FIG. 12, the electronic device 1200 may further include another dedicated processor such as an application processor (application processor, AP) and an NPU, and another subsystem such as a power management subsystem, a clock management subsystem, and a power consumption management subsystem.

The memory may be the storage device 50 shown in FIG. 5, and the memory may perform the method shown in FIG. 6, FIG. 7, or FIG. 8. Alternatively, the memory includes a storage controller, and the storage controller in the memory may perform the method shown in FIG. 6, FIG. 7, or FIG. 8.

The foregoing parts of the electronic device 1200 are coupled through a connector. For example, the connector includes various types of interfaces, transmission lines, buses, and the like. These interfaces are usually electrical communication interfaces, but may alternatively be mechanical interfaces or interfaces in another form. This is not limited in this embodiment.

Optionally, the CPU may be a single-core (single-CPU) processor or a multi-core (multi-CPU) processor. Optionally, the CPU may be a processor group including a plurality of processors, and the plurality of processors are coupled to each other through one or more buses. In an optional case, the CPU implements any power-off detection method in the foregoing method embodiments by invoking program instructions stored in an on-chip memory or an off-chip memory. In an optional case, the CPU and the MCU jointly implement any power-off detection method in the foregoing method embodiments. For example, the CPU completes some steps in the power-off detection method, and the MCU completes other steps in the power-off detection method. In an optional case, the AP or the another dedicated processor implements any power-off detection method in the foregoing method embodiments by invoking program instructions stored in an on-chip memory or an off-chip memory.

The transmission interface may be an interface for receiving and sending data by a processor chip. The transmission interface usually includes a plurality of interfaces. In an optional case, the transmission interface may include an inter-integrated circuit (inter-integrated circuit, I2C) interface, a serial peripheral interface (serial peripheral interface, SPI), a universal asynchronous receiver/transmitter (universal asynchronous receiver-transmitter, UART) interface, a general-purpose input/output (general-purpose input/output, GPIO) interface, and the like. It may be understood that these interfaces may implement different functions by sharing a same physical interface.

In an optional case, the transmission interface may alternatively include a high definition multimedia interface (high definition multimedia interface, HDMI), a V-By-One interface, an embedded display port (embedded display port, eDP), a mobile industry processor interface (mobile industry processor interface, MIPI), a display port (DP), or the like.

In an optional case, the foregoing parts are integrated into a same chip. In another optional case, the memory may be an independent chip.

The WLAN subsystem may include, for example, a radio frequency circuit and a baseband.

The chip in embodiments of this application is a system manufactured on a same semiconductor substrate by using an integrated circuit technology, and is also referred to as a semiconductor chip. The chip may be a set of integrated circuits formed on the substrate (which is usually a semiconductor material such as silicon) by using the integrated circuit technology, and an outer layer of the chip is usually packaged with a semiconductor packaging material. The integrated circuit may include various function components. Each type of function component includes a logic gate circuit, a metal oxide semiconductor (metal-oxide-semiconductor, MOS) transistor, or a transistor such as a bipolar transistor or a diode, and may also include another part such as a capacitor, a resistor, or an inductor. Each function component may independently operate or operate under action of necessary driver software, and may implement various functions such as communication, operation, or storage.

An embodiment of this application further provides a storage controller, where the storage controller is coupled to a memory, the memory is a non-volatile memory, and a volatile storage unit is disposed in the memory; and the storage controller is configured to perform the method described in FIG. 6, FIG. 7, or FIG. 8.

An embodiment of this application further provides a storage device, including a storage controller and a memory, where the storage controller is coupled to the memory, the memory is a non-volatile memory, and a volatile storage unit is disposed in the memory; and the storage controller is configured to perform the method described in FIG. 6, FIG. 7, or FIG. 8.

An embodiment of this application further provides an electronic device, where the electronic device includes a storage controller or a storage device, the storage device includes a storage controller, and the storage controller is configured to perform the method described in FIG. 6, FIG. 7, or FIG. 8.

An embodiment of this application further provides a computer-readable storage medium, where the computer-readable storage medium includes a computer program, and when the computer program is run on a computer or a processor, the computer or the processor is enabled to perform the method described in FIG. 6, FIG. 7, or FIG. 8.

An embodiment of this application further provides a computer program product, where the computer program product includes a computer program, and when the computer program is run on a computer or a processor, the computer or the processor is enabled to perform the method described in FIG. 6, FIG. 7, or FIG. 8.

It may be understood that sequence numbers of the foregoing processes do not mean execution sequences in various embodiments of this application. The execution sequences of the processes may be determined according to functions and internal logic of the processes, and shall not be construed as any limitation on the implementation processes of embodiments of this application.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it shall not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it may be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The foregoing units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the function is implemented in a form of a software function unit and sold or used as an independent product, the function may be stored in a computer-readable storage medium. Based on such an understanding, the technical solutions of this application essentially, or the part contributing to the current technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application.

A sequence of the steps of the method in embodiments of this application may be adjusted, combined, or removed based on an actual requirement. In addition, for terms and explanations in embodiments of this application, refer to corresponding descriptions in other embodiments.

The modules in the apparatus in embodiments of this application may be combined, divided, and deleted based on an actual requirement.

The foregoing embodiments are merely used to describe the technical solutions of this application, but not limit the technical solutions of this application. Although this application is described in detail with reference to the foregoing embodiments, a person of ordinary skill in the art may understand that they may still modify the technical solutions described in the foregoing embodiments, or perform equivalent replacement on some technical features. However, these modifications or replacements do not make the essence of the corresponding technical solutions depart from the scope of the technical solutions in embodiments of this application.

## Claims

1. A power-off detection method, applied to a storage controller, wherein the storage controller is coupled to a memory, the memory is a non-volatile memory, and a volatile storage unit is disposed in the memory; and the method comprises:
writing target data into the volatile storage unit before the storage controller enters a low power consumption mode;
obtaining data from the volatile storage unit after detecting a wake-up request for exiting the low power consumption mode;
determining, based on the target data and the data obtained from the volatile storage unit, whether the memory has been powered off during the low power consumption mode of the storage controller; and
initializing the memory if the memory has been powered off during the low power consumption mode of the storage controller.

2. The method according to claim 1, wherein the determining, based on the target data and the data obtained from the volatile storage unit, whether the memory has been powered off during the low power consumption mode of the storage controller comprises:
determining, based on the data obtained from the volatile storage unit, whether the target data stored in the volatile storage unit has changed during the low power consumption mode of the storage controller; and
determining, based on whether the target data stored in the volatile storage unit has changed during the low power consumption mode of the storage controller, whether the memory has been powered off during the low power consumption mode of the storage controller.

3. The method according to claim 2, wherein if the target data stored in the volatile storage unit has not changed during the low power consumption mode of the storage controller, the memory has not been powered off during the low power consumption mode of the storage controller; or
if the target data stored in the volatile storage unit has changed during the low power consumption mode of the storage controller, the memory has been powered off during the low power consumption mode of the storage controller.

4. The method according to any one of claims 1 to 3, wherein the volatile storage unit is any one of the following: a cache or a random access memory.

5. The method according to any one of claims 1 to 4, wherein the volatile storage unit is a status register, and the target data corresponds to a status of the status register; and the determining, based on the target data and the data obtained from the volatile storage unit, whether the memory has been powered off during the low power consumption mode of the storage controller comprises:
determining, based on data obtained from the status register, whether the status of the status register has changed during the low power consumption mode of the storage controller; and
determining, based on whether the status of the status register has changed during the low power consumption mode of the storage controller, whether the memory has been powered off during the low power consumption mode of the storage controller.

6. A power-off detection method, applied to a storage controller, wherein the storage controller is coupled to a memory, the memory is a non-volatile memory, and a volatile storage unit is disposed in the memory; and the method comprises:
determining, based on whether target data stored in the volatile storage unit has changed during a low power consumption mode of the storage controller, whether the memory has been powered off during the low power consumption mode of the storage controller.

7. The method according to claim 6, wherein if the target data stored in the volatile storage unit has not changed during the low power consumption mode of the storage controller, the memory has not been powered off during the low power consumption mode of the storage controller; or
if the target data stored in the volatile storage unit has changed during the low power consumption mode of the storage controller, the memory has been powered off during the low power consumption mode of the storage controller.

8. The method according to claim 6 or 7, wherein before the determining, based on whether target data stored in the volatile storage unit has changed during a low power consumption mode of the storage controller, whether the memory has been powered off during the low power consumption mode of the storage controller, the method further comprises:
writing the target data into the volatile storage unit before the storage controller enters the low power consumption mode;
obtaining data from the volatile storage unit after detecting a wake-up request for exiting the low power consumption mode; and
determining, based on the data obtained from the volatile storage unit, whether the target data stored in the volatile storage unit has changed during the low power consumption mode of the storage controller.

9. The method according to any one of claims 6 to 8, wherein the volatile storage unit is any one of the following: a cache or a random access memory.

10. The method according to any one of claims 6 to 9, wherein the volatile storage unit is a status register, and the target data corresponds to a status of the status register; and the determining, based on whether target data stored in the volatile storage unit has changed during a low power consumption mode of the storage controller, whether the memory has been powered off during the low power consumption mode of the storage controller comprises:
determining, based on whether the status of the status register has changed during the low power consumption mode of the storage controller, whether the memory has been powered off during the low power consumption mode of the storage controller.

11. The method according to claim 10, wherein before the determining, based on whether the status of the status register has changed during the low power consumption mode of the storage controller, whether the memory has been powered off during the low power consumption mode of the storage controller, the method further comprises:
writing the target data into the status register before the storage controller enters the low power consumption mode;
obtaining data from the status register after detecting the wake-up request for exiting the low power consumption mode; and
determining, based on the data obtained from the status register, whether the status of the status register has changed during the low power consumption mode of the storage controller.

12. The method according to any one of claims 6 to 11, wherein if the memory has been powered off during the low power consumption mode of the storage controller, the method further comprises:
initializing the memory before the storage controller exits the low power consumption mode.

13. A power-off detection apparatus, used for a storage controller, wherein the storage controller is coupled to a memory, the memory is a non-volatile memory, and a volatile storage unit is disposed in the memory; and the apparatus comprises a processing unit, and the processing unit is configured to:
write target data into the volatile storage unit before the storage controller enters a low power consumption mode;
obtain data from the volatile storage unit after detecting a wake-up request for exiting the low power consumption mode;
determine, based on the target data and the data obtained from the volatile storage unit, whether the memory has been powered off during the low power consumption mode of the storage controller; and
initialize the memory if the memory has been powered off during the low power consumption mode of the storage controller.

14. The apparatus according to claim 13, wherein the processing unit is specifically configured to:
determine, based on the data obtained from the volatile storage unit, whether the target data stored in the volatile storage unit has changed during the low power consumption mode of the storage controller; and
determine, based on whether the target data stored in the volatile storage unit has changed during the low power consumption mode of the storage controller, whether the memory has been powered off during the low power consumption mode of the storage controller.

15. The apparatus according to claim 14, wherein the processing unit is specifically configured to:
if the target data stored in the volatile storage unit has not changed during the low power consumption mode of the storage controller, determine that the memory has not been powered off during the low power consumption mode of the storage controller; or
if the target data stored in the volatile storage unit has changed during the low power consumption mode of the storage controller, determine that the memory has been powered off during the low power consumption mode of the storage controller.

16. The apparatus according to any one of claims 13 to 15, wherein the volatile storage unit is any one of the following: a cache or a random access memory.

17. The apparatus according to any one of claims 13 to 16, wherein the volatile storage unit is a status register, and the target data corresponds to a status of the status register; and the processing unit is specifically configured to:
determine, based on data obtained from the status register, whether the status of the status register has changed during the low power consumption mode of the storage controller; and
determine, based on whether the status of the status register has changed during the low power consumption mode of the storage controller, whether the memory has been powered off during the low power consumption mode of the storage controller.

18. A power-off detection apparatus, used for a storage controller, wherein the storage controller is coupled to a memory, the memory is a non-volatile memory, and a volatile storage unit is disposed in the memory; and the apparatus comprises:
a processing unit, configured to determine, based on whether target data stored in the volatile storage unit has changed during a low power consumption mode of the storage controller, whether the memory has been powered off during the low power consumption mode of the storage controller.

19. The apparatus according to claim 18, wherein the processing unit is specifically configured to:
if the target data stored in the volatile storage unit has not changed during the low power consumption mode of the storage controller, determine that the memory has not been powered off during the low power consumption mode of the storage controller; or
if the target data stored in the volatile storage unit has changed during the low power consumption mode of the storage controller, determine that the memory has been powered off during the low power consumption mode of the storage controller.

20. The apparatus according to claim 18 or 19, wherein before the determining, based on whether target data stored in the volatile storage unit has changed during a low power consumption mode of the storage controller, whether the memory has been powered off during the low power consumption mode of the storage controller, the processing unit is further configured to:
write the target data into the volatile storage unit before the storage controller enters the low power consumption mode;
obtain data from the volatile storage unit after detecting a wake-up request for exiting the low power consumption mode; and
determine, based on the data obtained from the volatile storage unit, whether the target data stored in the volatile storage unit has changed during the low power consumption mode of the storage controller.

21. The apparatus according to any one of claims 18 to 20, wherein the volatile storage unit is any one of the following: a cache or a random access memory.

22. The apparatus according to claim 21, wherein the volatile storage unit is a status register, and the target data corresponds to a status of the status register; and the processing unit is specifically configured to:
determine, based on whether the status of the status register has changed during the low power consumption mode of the storage controller, whether the memory has been powered off during the low power consumption mode of the storage controller.

23. The apparatus according to claim 22, wherein the processing unit is further configured to:
write the target data into the status register before the storage controller enters the low power consumption mode;
obtain data from the status register after detecting the wake-up request for exiting the low power consumption mode; and
determine, based on the data obtained from the status register, whether the status of the status register has changed during the low power consumption mode of the storage controller.

24. The apparatus according to any one of claims 18 to 23, wherein if the memory has been powered off during the low power consumption mode of the storage controller, the processing unit is further configured to:
initialize the memory before the storage controller exits the low power consumption mode.

25. A storage controller, wherein the storage controller is coupled to a memory, the memory is a non-volatile memory, and a volatile storage unit is disposed in the memory; and the storage controller is configured to perform the method according to any one of claims 1 to 5 or 6 to 12.

26. A storage device, comprising the storage controller according to claim 25 and a memory, wherein the storage controller is coupled to the memory, the memory is a non-volatile memory, and a volatile storage unit is disposed in the memory.

27. A computer-readable storage medium, wherein the computer-readable storage medium comprises a computer program, and when the computer program is run on a computer or a processor, the computer or the processor is enabled to perform the method according to any one of claims 1 to 5 or 6 to 12.

28. A computer program product, wherein the computer program product comprises a computer program, and when the computer program is run on a computer or a processor, the computer or the processor is enabled to perform the method according to any one of claims 1 to 5 or 6 to 12.
